# EUROPEAN PATENT APPLICATION

(11) **EP 4 557 356 A1**
(43) Date of publication of application: **21.05.2025**
(21) Application number: 24210079.0
(22) Date of filing: 31.10.2024
(51) Int. Cl.: H01L 21/768, H01L 23/522, H01L 23/528, H01L 23/532

(54) **INTEGRATED CIRCUIT HAVING UPPER LINES WITH DIFFERENT METALS AND WIDTHS, AND RELATED FABRICATION METHOD**

(30) Priority: 14.11.2023 US 202363598597 P; 01.05.2024 US 202418651944
(71) Applicant: Samsung Electronics Co., Ltd., Suwon-si, Gyeonggi-do 16677 (KR)
(72) Inventor: CHOI, Jaemyung, San Jose, CA, 95134 (US); SEO, Kang-Ill, San Jose, CA, 95134 (US)
(74) Representative: Kuhnen & Wacker Patent- und Rechtsanwaltsbüro PartG mbB

(57) **Abstract**

Integrated circuit (IC) devices are provided. An IC device includes a back-end-of-line (BEOL) region that includes a first via and a second via on a first lower metal line and a second lower metal line, respectively. The BEOL region includes a first upper metal line coupled to the first lower metal line by the first via, and a second upper metal line coupled to the second lower metal line by the second via. The first upper metal line and the first via each include a first metal. The second upper metal line and the second via each include a second metal that is different from the first metal. Moreover, the second upper metal line is wider than the first upper metal line. Related methods of forming BEOL regions of IC devices are also provided.

## Description

### TECHNICAL FIELD

The present disclosure generally relates to the field of integrated circuit (IC) devices and, more particularly, to IC devices having metal lines in a back-end-of-line (BEOL) region thereof, and to methods of fabricating such IC devices.

### BACKGROUND OF THE INVENTION

A BEOL region of an IC device may include multiple vertical levels of metal lines (e.g., interconnect wires). Upper metal lines in the BEOL region may be coupled to lower metal lines in the BEOL region by metal vias. For example, a single upper metal line may be coupled to two lower metal lines by respective metal vias.

### SUMMARY OF THE INVENTION

An IC device, according to some embodiments herein, may include a BEOL region including a first lower metal line and a second lower metal line that extend in parallel with each other in a first direction. The BEOL region may include a first via and a second via on the first lower metal line and the second lower metal line, respectively. The BEOL region may include a first upper metal line and a second upper metal line that extend in a second direction perpendicular to the first direction. The first upper metal line may be coupled to the first lower metal line by the first via. The second upper metal line may be coupled to the second lower metal line by the second via. The first upper metal line and the first via may each include a first metal. The second upper metal line and the second via may each include a second metal that is different from the first metal. Moreover, the second upper metal line may be wider, in the first direction, than the first upper metal line.

An IC device, according to some embodiments herein, may include a BEOL region including a first lower metal line and a second lower metal line that extend in parallel with each other at a first vertical level. The BEOL region may include a ruthenium via at a second vertical level and on the first lower metal line. The BEOL region may include a copper via at the second vertical level and on the second lower metal line. Moreover, the BEOL region may include a ruthenium upper metal line and a copper upper metal line that are at a third vertical level and are collinear in a direction in which the first lower metal line and the second lower metal line are spaced apart from each other. The ruthenium upper metal line may be coupled to the first lower metal line by the ruthenium via. The copper upper metal line may be coupled to the second lower metal line by the copper via. The copper upper metal line may be wider, in a direction in which the first lower metal line and the second lower metal line extend in parallel, than the ruthenium upper metal line.

A method of forming a BEOL region of an IC device, according to some embodiments herein, may include forming a first metal layer. The method may include forming a first lower metal line, a second lower metal line, and a first via by performing a subtractive etch of the first metal layer. The method may include forming a second metal layer on the first lower metal line, the second lower metal line, and the first via. The method may include forming a first upper metal line that is coupled to the first lower metal line by the first via, by removing a portion of the second metal layer that is on the second lower metal line. The first upper metal line and the first via may each include a first metal. Moreover, the method may include forming, by a dual-damascene process, a second upper metal line and a second via that each include a second metal that is different from the first metal. The second upper metal line may be coupled to the second lower metal line by the second via.

### BRIEF DESCRIPTION OF THE DRAWINGS

FIG. 1A is a schematic block diagram of an IC device according to some embodiments herein.
FIG. 1B is an example plan view of the BEOL region of the IC device of FIG. 1A.
FIG. 1C is an example cross-sectional view of the BEOL region of FIG. 1B.
FIGs. 1D and 1E are example top views of the vias of FIG. 1C.
FIGs. 2A-2J are cross-sectional views illustrating operations of forming a BEOL region according to some embodiments herein.
FIG. 3 is a flowchart corresponding to the operations shown in FIGs. 2A-2J.

### DETAILED DESCRIPTION

Pursuant to embodiments herein, an IC device is provided that includes a BEOL region having upper metal lines that have different metals and widths. As a result, interconnect resistance in the BEOL region may be reduced. For example, embodiments herein can provide a narrow, ruthenium (Ru) upper line and a wide, copper (Cu) upper line.

The resistivity of a Cu metal line can increase as its width decreases below ten nanometers (nm), as discussed in Scaling Properties of Ru, Rh, and Ir for Future Generation Metallization by Min-Sik Kim et al., IEEE Journal of the Electron Devices Society, volume 11, pages 399-405 (July 2023), which is incorporated by reference herein in its entirety. For a sub-ten-nm upper metal line (i.e., an upper metal line less than 100 Angstroms in width), metals such as Ru, rhodium (Rh), and iridium (Ir) have lower resistivities than Cu, and thus can advantageously be used instead of Cu. The increased resistivity of Cu below ten nm is related to electron scattering at surfaces and grain boundaries. For a wide upper metal line, however, Cu may have a lower resistivity than Ru. Accordingly, embodiments herein advantageously use both a low-resistance narrow metal line (e.g., a narrow Ru line) and a low-resistance wide metal line (e.g., a wide Cu line).

Example embodiments will be described in greater detail with reference to the attached figures.

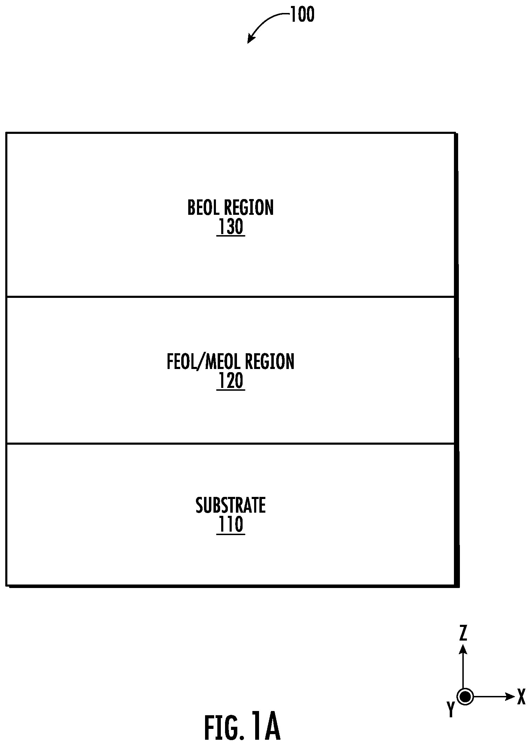

FIG. 1A is a schematic block diagram of an IC device 100 according to some embodiments. The device 100 may be, for example, a semiconductor memory device for storing data and/or a semiconductor logic device for processing data. The device 100 includes a substrate (e.g., a semiconductor substrate) 110, a BEOL region 130 that is on the substrate 110, and a front-end-of-line (FEOL) and/or middle-end-of-line (MEOL) region 120 that is between (in a vertical direction Z) the BEOL region 130 and the substrate 110. As an example, the FEOL/MEOL region 120 may include devices such as transistors, capacitors, and/or resistors. Moreover, the BEOL region 130 may include interconnect wires, vias, and dielectric structures.

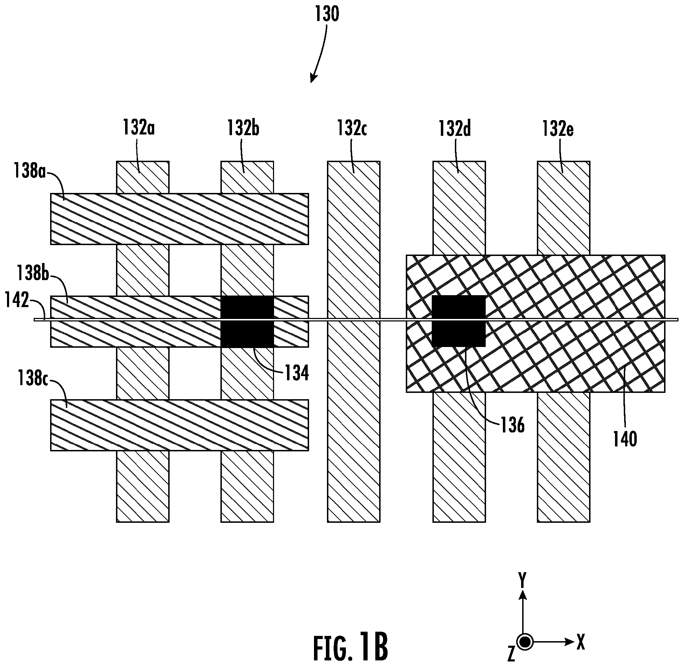

FIG. 1B is an example plan view of the BEOL region 130 of FIG. 1A. As shown in FIG. 1B, the BEOL region 130 comprises a plurality of BEOL elements, including various metal lines (e.g., metal/interconnect wires) and metal vias. The metal lines include lower metal lines 132a-132e, narrow upper metal lines 138a-138c, and a wide upper metal line 140. The metal vias include vias 134 and 136.

The lower metal lines 132a-132e extend in a horizontal direction Y in parallel with each other, and are spaced apart from each other in another horizontal direction X, which intersects (e.g., is perpendicular to) the direction Y. The narrow upper metal lines 138a-138c cross the lower metal lines 132a and 132b, and the wide upper metal line 140 crosses the lower metal lines 132d and 132e. The narrow upper metal lines 138a-138c extend in parallel with each other in the direction X, are spaced apart from each other in the direction Y, and are at the same vertical level, in the direction Z, as the wide upper metal line 140. For example, the narrow upper metal lines 138a-138c may have coplanar uppermost surfaces and/or coplanar lowermost surfaces.

The lower metal line 132c is between the lower metal lines 132b and 132d. In some embodiments, the lower metal line 132c is not crossed by any of the narrow upper metal lines 138a-138c or the wide upper metal line 140. Moreover, no other lower metal line 132 (except for the lower metal line 132c) may be between the lower metal lines 132b and 132d.

The narrow upper metal line 138b may be coupled to the lower metal line 132b by the via 134, and the wide upper metal line 140 may be coupled to the lower metal line 132d by the via 136. For simplicity of illustration, locations of the vias 134 and 136 are indicated on the narrow upper metal line 138b and the wide upper metal line 140, respectively, in FIG. 1B. It will be understood, however, that the vias 134 and 136 are underneath the narrow upper metal line 138b and the wide upper metal line 140, respectively, and thus may not be visible on top of the narrow upper metal line 138b and the wide upper metal line 140. The vias 134 and 136 may be at the same vertical level, in the direction Z, as each other, which is below a vertical level of the narrow upper metal lines 138a-138c and the wide upper metal line 140. As an example, the vias 134 and 136 may have coplanar uppermost surfaces and/or coplanar lowermost surfaces.

The via 136 is collinear with the via 134 in the direction X. Accordingly, an axis 142 that extends in the direction X may pass through both the via 134 and the via 136. Moreover, the wide upper metal line 140 is spaced apart from the narrow upper metal line 138b along the axis 142. For example, the wide upper metal line 140 may be spaced apart from the narrow upper metal line 138b by more than a width, in the direction X, of the lower metal line 132c that is therebetween.

The wide upper metal line 140 is wider, in the direction Y, than the narrow upper metal line 138b. For example, the wide upper metal line 140 may be at least twice as wide as the narrow upper metal line 138b. In some embodiments, the width of the narrow upper metal line 138b may be less than 10 nm, and the width of the wide upper metal line 140 may be more than 10 nm. Moreover, the wide upper metal line 140 and the narrow upper metal line 138b comprise different metals. For example, the wide upper metal line 140 may comprise Cu, and the narrow upper metal line 138b may comprise Ru, Rh, or Ir.

According to some embodiments, a pitch (in the direction Y) of the narrow upper metal lines 138a-138c may be twice the width of each of the narrow upper metal lines 138a-138c. The narrow upper metal lines 138a and 138b may thus be spaced apart from each other by a distance equal to the width of each of the narrow upper metal lines 138a-138c. Likewise, the narrow upper metal lines 138b and 138c may be spaced apart from each other by a distance equal to the width of each of the narrow upper metal lines 138a-138c. In some embodiments, the distance between two immediately-adjacent ones of the narrow upper metal lines 138a-138c may be less than 10 nm, and each of the narrow upper metal lines 138a-138c may have a width of less than 10 nm. Accordingly, a pitch of the narrow upper metal lines 138a-138c may be less than 20 nm.

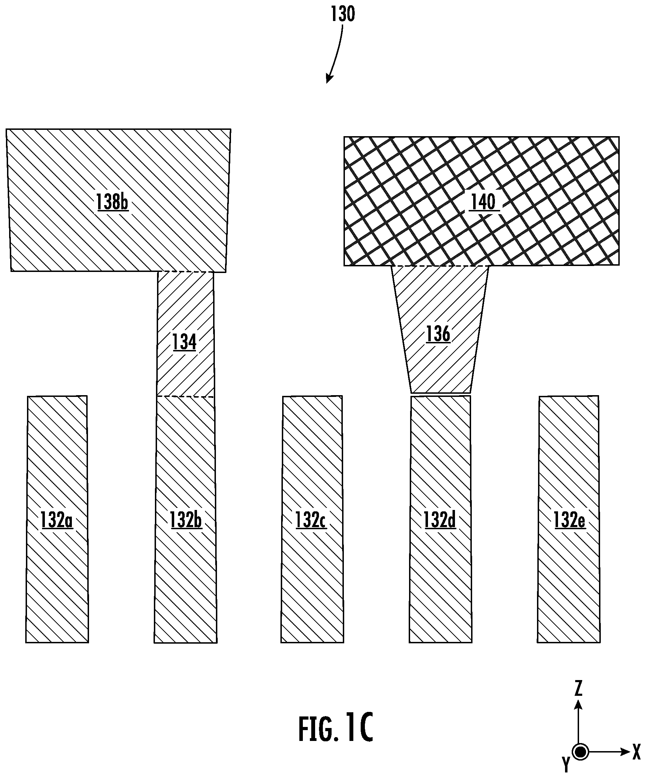

FIG. 1C is an example cross-sectional view of the BEOL region 130 of FIG. 1B along the axis 142 (FIG. 1B). As shown in FIG. 1C, the narrow upper metal line 138b is coupled to the lower metal line 132b by the via 134, and the wide upper metal line 140 is coupled to the lower metal line 132d by the via 136. In some embodiments, the lower metal lines 132a-132e may comprise the same metal (e.g., Ru, Rh, or Ir) as the via 134 and the narrow upper metal line 138b. Moreover, the wide upper metal line 140 may comprise the same metal (e.g., Cu) as the via 136. The metal of the wide upper metal line 140 and the via 136 may be different from the metal of the narrow upper metal line 138b and the via 134. Accordingly, the lower metal lines 132a-132e may comprise a different metal from that of the via 136 and the wide upper metal line 140.

FIG. 1C shows three vertical levels, in the direction Z, of the BEOL region 130. The lower metal lines 132a-132e are each at a low (e.g., lowest) level, the vias 134 and 136 are each at a middle level, and the narrow upper metal line 138b and the wide upper metal line 140 are each at a high (e.g., highest) level. For example, an uppermost surface of the narrow upper metal line 138b may be coplanar with an uppermost surface of the wide upper metal line 140, and/or a lowermost surface of the narrow upper metal line 138b may be coplanar with a lowermost surface of the wide upper metal line 140.

In some embodiments, the via 134 may have a different shape from that of the via 136. For example, the via 134 may have a constant width, in the direction X, from the top of the via 134 to the bottom of the via 134. The via 136, on the other hand, may have a tapered width, in the direction X, that narrows as it approaches the lower metal line 132d in the direction Z.

For simplicity of illustration, only metal elements of the BEOL region 130 are shown in FIG. 1C. It will be understood, however, that the BEOL region 130 may include one or more insulating (e.g., dielectric) layers having the metal elements therein. As an example, an insulating layer may electrically isolate the narrow upper metal line 138b from the wide upper metal line 140.

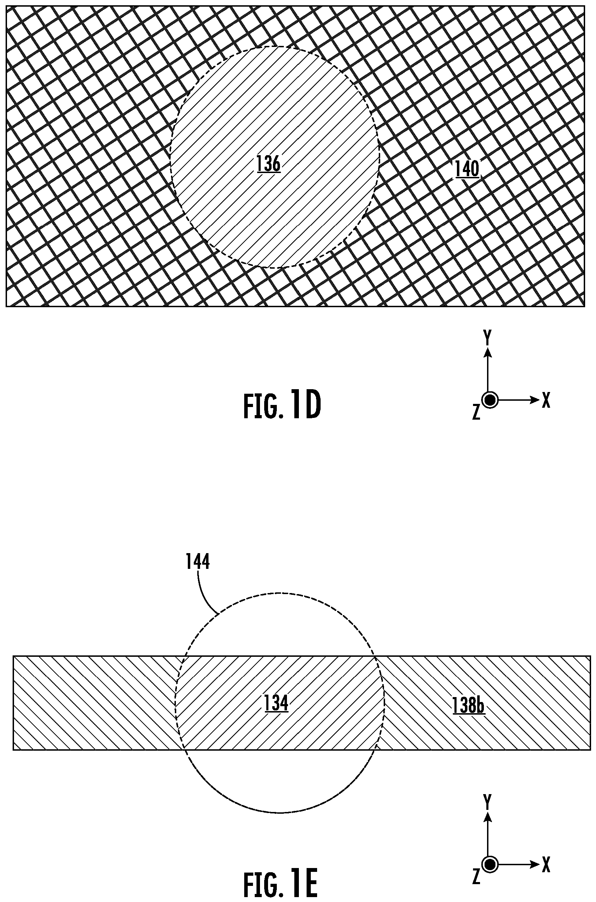

FIGs. 1D and 1E are example top views of the vias 134 and 136 of FIG. 1C. For simplicity of illustration, the location of the via 136 is indicated on the wide upper metal line 140 in FIG. 1D, and the location of the via 134 is indicated on the narrow upper metal line 138b in FIG. 1E. It will be understood, however, that the vias 134 and 136 are underneath the narrow upper metal line 138b and the wide upper metal line 140, respectively, and thus may not be visible on top of the narrow upper metal line 138b and the wide upper metal line 140.

As shown in FIG. 1D, the via 136 may have a cylindrical shape with a diameter, in the direction Y, that is narrower than a width of the wide upper metal line 140 in the direction Y. In contrast, as shown in FIG. 1E, the via 134 may have a rectangular shape with a width, in the direction Y, that is equal to a width of the narrow upper metal line 138b in the direction Y.

For simplicity of illustration, FIG. 1E depicts a circular outline 144 superimposed on the via 134 to indicate the size of the via 136 relative to the size of the via 134. FIG. 1E thus shows that a widest portion (e.g., the diameter) of the via 136 is wider, in the direction Y, than a widest portion of the via 134. For example, the vias 134 and 136 may each be formed by a self-aligned via process, and therefore may each have a via size corresponding to the width, in the direction Y, of the upper metal line thereon. The via 134 may thus be narrower than the via 136 because the narrow upper metal line 138b is narrower than the wide upper metal line 140.

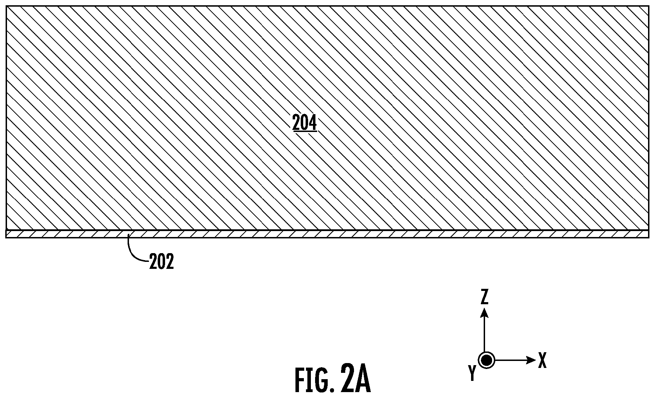

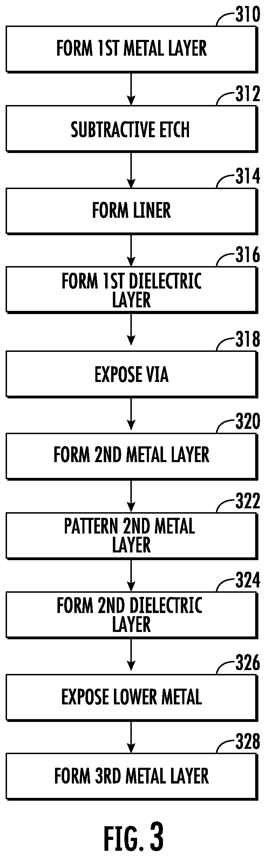

FIGs. 2A-2J are cross-sectional views illustrating operations of forming a BEOL region 130 (FIG. 1A) according to some embodiments herein. FIG. 3 is a flowchart corresponding to the operations shown in FIGs. 2A-2J.

As shown in FIGs. 2A and 3, a metal adhesion layer 202 may be formed, and a first metal layer 204 may be formed (Block 310) on the adhesion layer 202. For example, the metal layer 204 may comprise Ru and may be formed by a blanket Ru fill. The adhesion layer 202 may comprise a metal that improves adhesion of the metal layer 204 to an underlying insulating layer (e.g., an oxide layer) of the BEOL region 130 or the FEOL/MEOL region 120 (FIG. 1A). As an example, the adhesion layer 202 may comprise aluminum (Al) or chromium (Cr).

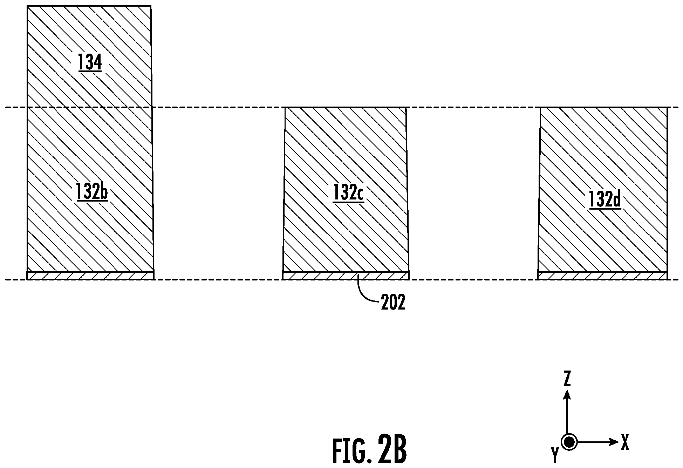

As shown in FIGs. 2B and 3, a subtractive etch (Block 312) may be performed of the metal layer 204 (FIG. 2A) to form lower metal lines 132b-132d and a via 134. As an example, subtractive Ru top-via patterning may be performed. For simplicity of illustration, lower metal lines 132a and 132e (FIG. 1B) are omitted from view in FIG. 2B. It will be understood, however, that the lower metal lines 132a-132e may all be formed by the subtractive etch of the metal layer 204.

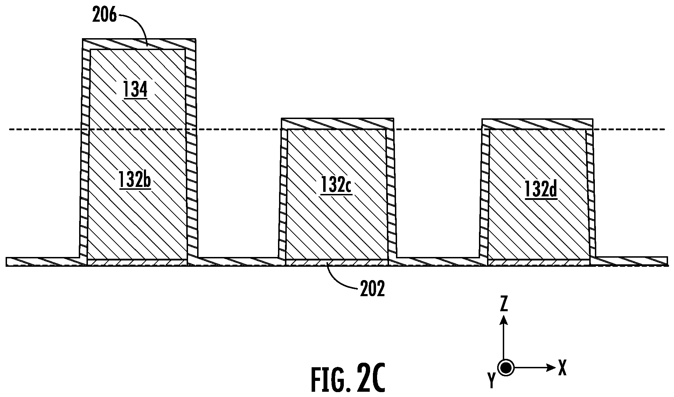

As shown in FIGs. 2C and 3, an insulating liner 206 may be conformally formed (Block 314) on the lower metal lines 132 and the via 134. For example, the liner 206 may be formed on sidewalls and an uppermost surface of the via 134, sidewalls of the lower metal line 132b, and sidewalls and an uppermost surface of each of the lower metal lines 132c and 132d. In some embodiments, the liner 206 may comprise nitride and may be formed by conformal nitride deposition.

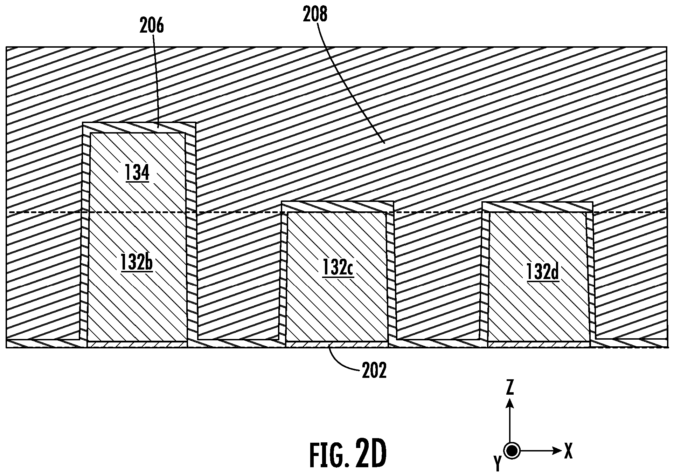

As shown in FIGs. 2D and 3, a first dielectric layer 208 may be formed (Block 316) on the lower metal lines 132 and the via 134 after forming the liner 206. For example, the dielectric layer 208 may be formed between sidewalls of the lower metal lines 132, and on uppermost surfaces of the via 134 and the lower metal lines 132. In some embodiments, the dielectric layer 208 may be formed by performing a low-k material fill on the lower metal lines 132 and the via 134.

As used herein, the term "low-k" refers to a material that has a smaller dielectric constant than silicon dioxide. The low-k material may include, for example, fluorine-doped silicon dioxide, organosilicate glass, carbon-doped oxide, porous silicon dioxide, porous organosilicate glass, a spin-on organic polymeric dielectric, or a spin-on silicon based polymeric dielectric.

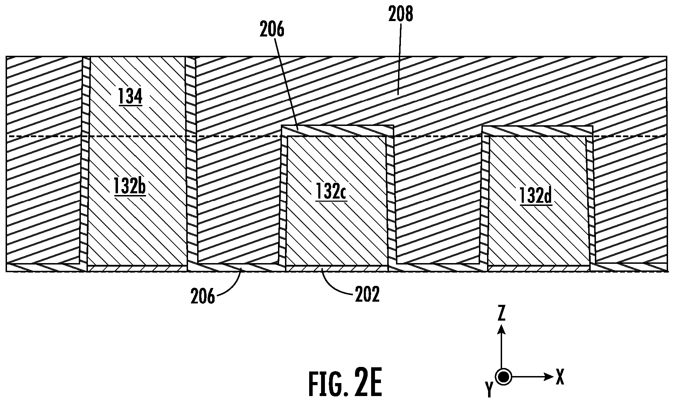

As shown in FIGs. 2E and 3, a portion of the dielectric layer 208 may be removed to expose (Block 318) the uppermost surface of the via 134. For example, the dielectric layer 208 may be planarized, such as by chemical-mechanical planarization (CMP), to reveal the uppermost surface of the via 134. After the planarization, an uppermost surface of the dielectric layer 208 on the lower metal lines 132c and 132d may be coplanar with, or adjacent a level of, the uppermost surface of the via 134.

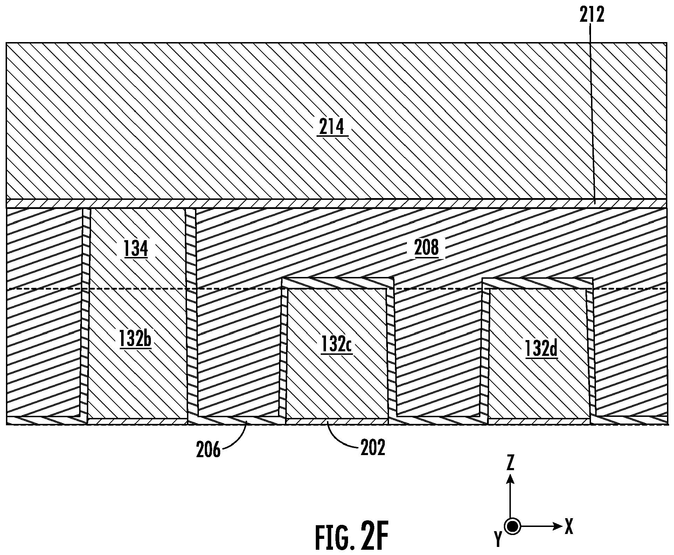

As shown in FIGs. 2F and 3, a second metal layer 214 may be formed (Block 320) on the exposed uppermost surface of the via 134 and on the planarized dielectric layer 208. The metal layer 214 may comprise the same metal as the via 134 and/or the lower metal lines 132. For example, the metal layer 214 may comprise Ru and may be formed by Ru deposition on the exposed uppermost surface of the via 134 and on the planarized dielectric layer 208. In some embodiments, a metal adhesion layer 212 may be formed on the exposed uppermost surface of the via 134 and on the planarized dielectric layer 208 before forming the metal layer 214. The adhesion layer 212 may comprise a metal (e.g., Al or Cr) that improves adhesion of the metal layer 214 to the dielectric layer 208.

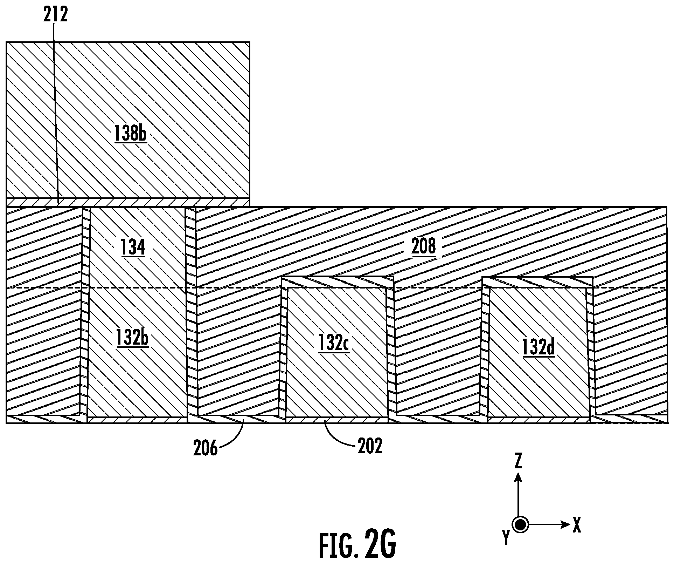

As shown in FIGs. 2G and 3, the metal layer 214 (FIG. 2F) may be patterned (Block 322) to remove portions of the metal layer 214 that overlap (in the direction Z) the lower metal lines 132c-132e. After patterning (e.g., etching) the metal layer 214, it may overlap the lower metal lines 132a and 132b without overlapping the lower metal lines 132c-132e. Moreover, portions of the adhesion layer 212 that overlap the lower metal lines 132c-132e may also be removed. After patterning the metal layer 214, the portion of the metal layer 214 that remains serves as the narrow upper metal line 138b. In some embodiments, the adhesion layer 212 intervenes between (in the direction Z) the via 134 and the narrow upper metal line 138b. As an example, the adhesion layer 212 may contact an uppermost surface of the via 134 and a lowermost surface of the narrow upper metal line 138b.

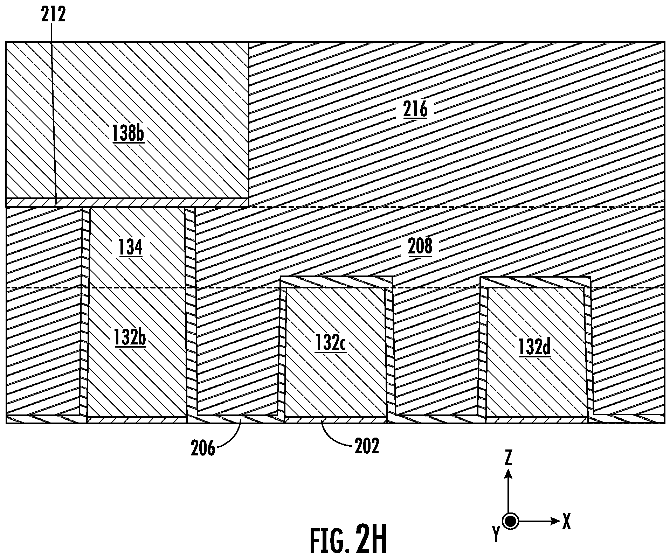

As shown in FIGs. 2H and 3, a second dielectric layer 216 may be formed (Block 324) on the uppermost surface of the first dielectric layer 208 and on exposed sidewalls of the narrow upper metal line 138b. For example, the dielectric layer 216 may be formed by inter-metal dielectric fill, followed by planarization. In some embodiments, the dielectric layer 216 may comprise oxide, and the planarization may be an oxide CMP.

According to some embodiments, the dielectric layer 216 may comprise the same insulating material as the dielectric layer 208. In other embodiments, the dielectric layer 216 may comprise an insulating material different from that of the dielectric layer 208. As an example, the dielectric layer 216 may comprise silicon dioxide, and the dielectric layer 208 may comprise an insulating material that has a smaller dielectric constant than silicon dioxide.

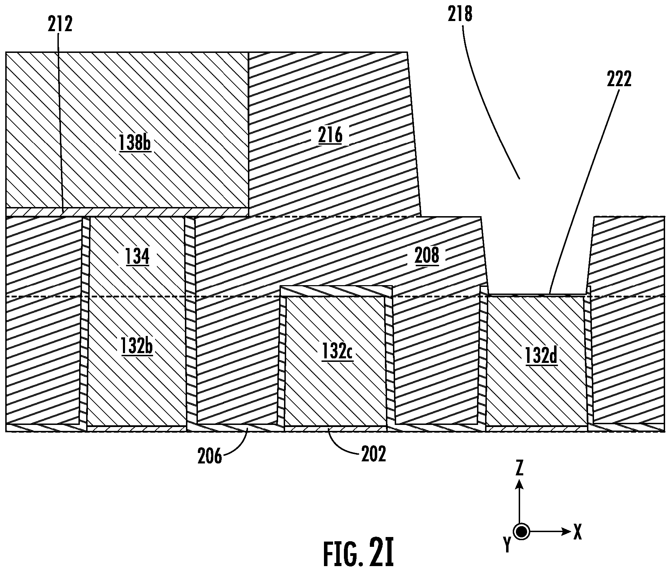

As shown in FIGs. 2I and 3, an uppermost surface 222 of the lower metal line 132d may be exposed (Block 326) by removing a portion of the dielectric layer 216 and a portion of the dielectric layer 208, thereby providing an opening 218 that extends through the dielectric layers 208 and 216. An upper portion (a portion in the dielectric layer 216) of the opening 218 may be wider (in the directions Y and X) than a lower portion thereof (a portion in the dielectric layer 208), as the upper portion is where the wide upper metal line 140 (FIG. 1C) will be formed, whereas the lower portion is where the via 136 (FIG. 1C) will be formed. Accordingly, the removal of the portion of the dielectric layer 216 and the portion of the dielectric layer 208 may comprise etching/patterning the dielectric layer 216 and the dielectric layer 208 in the shape of the wide upper metal line 140 and the shape of the via 136, respectively.

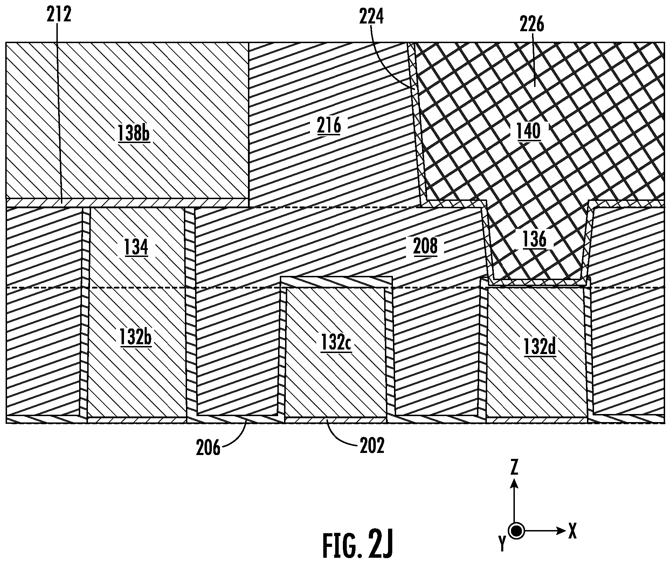

As shown in FIGs. 2J and 3, the wide upper metal line 140 and the via 136 may be formed by a dual-damascene process in which a third metal layer 226 is formed (Block 328) in both the narrow, lower portion of the opening 218 (FIG. 2I) and the wide, upper portion of the opening 218. For example, the metal layer 226 may comprise Cu, and may be formed by a Cu fill, followed by a Cu CMP.

In some embodiments, the dual-damascene process may include conformally forming a barrier metal 224 in the opening 218 and then forming the metal layer 226 on the barrier metal 224. Accordingly, the barrier metal 224 may contact the uppermost surface 222 (FIG. 2I) of the lower metal line 132d, a lowermost surface of the via 136, and sidewalls of the via 136 and the wide upper metal line 140. The barrier metal 224 may impede diffusion of metal (e.g., Cu) from the via 136 and the wide upper metal line 140 into adjacent materials. As an example, the barrier metal 224 may comprise Cr, nickel (Ni), nichrome, tantalum (Ta), hafnium (Hf), niobium (Nb), zirconium (Zr), vanadium (V), or tungsten (W). In contrast, no barrier metal (neither the barrier metal 224 nor any other barrier metal) may be between the via 134 and the lower metal line 132b, as the via 134 may comprise a non-Cu metal that is less likely to diffuse than Cu. Moreover, the dual-damascene process may include forming the opening 218 as described with respect to FIG. 2I.

IC devices 100 (FIG. 1A) according to embodiments herein may provide a number of advantages. These advantages include combining the benefits of two different schemes for forming metal vias in a single via layer. The first scheme is a top-via scheme (e.g., subtractive Ru top-via patterning), and the second scheme is a damascene-via scheme (e.g., for a Cu trench via). Embodiments herein may integrate these two schemes by forming, in a single via layer, both (i) a first via by a subtractive (e.g., metal-etch) process and (ii) a second via by a damascene process. The integration of these two schemes may be referred to herein as a "dual-via scheme."

The two schemes that are integrated together may be used with different metals, respectively, to benefit from properties of those metals that can vary with metal-line width. For example, due to electron scattering, Ru may benefit from lower resistance than Cu for the narrow upper metal line 138b (FIG. 1B), whereas Cu may benefit from lower resistance than Ru for the wide upper metal line 140 (FIG. 1B). Accordingly, embodiments herein may advantageously reduce resistance of interconnect wires in a BEOL region 130 (FIG. 1A) by using Cu in a wide area and Ru in a narrow area. Moreover, Cu may be used for both the wide upper metal line 140 and the (wide) via 136 coupled thereto, and Ru may be used for both the narrow upper metal line 138b and the (narrow) via 134 coupled thereto.

In contrast with embodiments herein, conventional BEOL techniques may not perform both a subtractive-metal process and a damascene process at the same upper level for upper metal lines (and/or at the same middle level for vias) to reduce resistance. Moreover, conventional BEOL techniques may lack two different metals at the same level, and fail to appreciate the low-resistivity benefits of using Ru in narrow areas and Cu in wide areas.

A scheme using subtractive Ru is a promising next-generation device candidate for achieving the challenging narrow pitch of some BEOL interconnect wires. Another challenge in the BEOL region 130 is achieving low-resistance upper metal lines and vias. The resistance of Ru may be relatively high for wide-pitch areas of the BEOL region 130. Embodiments herein, however, can decrease total chip resistance and improve chip performance by using a subtractive-metal process and a damascene process at the same level with different metals (e.g., Ru and Cu), respectively, at different metal-line widths.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. An integrated circuit, IC, device comprising a back-end-of-line, BEOL, region that comprises:
a first lower metal line and a second lower metal line that extend in parallel with each other in a first direction;
a first via and a second via on the first lower metal line and the second lower metal line, respectively; and
a first upper metal line and a second upper metal line that extend in a second direction perpendicular to the first direction,
wherein the first upper metal line is coupled to the first lower metal line by the first via,
wherein the second upper metal line is coupled to the second lower metal line by the second via,
wherein the first upper metal line and the first via each comprise a first metal,
wherein the second upper metal line and the second via each comprise a second metal that is different from the first metal, and
wherein the second upper metal line is wider, in the first direction, than the first upper metal line.

2. The IC device of Claim 1,
wherein the first metal comprises ruthenium, and
wherein the second metal comprises copper.

3. The IC device of Claim 1 or 2, wherein the first via and the second via are collinear in the second direction.

4. The IC device of any one of Claims 1 to 3, wherein a widest portion of the second via is wider, in the first direction, than a widest portion of the first via.

5. The IC device of any one of Claims 1 to 4,
wherein a width, in the second direction, of the second via is tapered toward the second lower metal line,
wherein the second via is narrower, in the first direction, than the second upper metal line,
wherein the first via has a constant width in the second direction, and
wherein the first via is equally wide, in the first direction, as the first upper metal line.

6. The IC device of any one of Claims 1 to 5, wherein the second upper metal line is at least twice as wide, in the first direction, as the first upper metal line.

7. The IC device of any one of Claims 1 to 6,
wherein the BEOL region further comprises a third lower metal line that extends in parallel with the first lower metal line and the second lower metal line in the first direction,
wherein the third lower metal line is between the first lower metal line and the second lower metal line, and
wherein, except for the third lower metal line, no other lower metal line is between the first lower metal line and the second lower metal line.

8. The IC device of any one of Claims 1 to 7, wherein the first upper metal line is at the same vertical level as the second upper metal line.

9. The IC device of any one of Claims 1 to 8, wherein the first via is at the same vertical level as the second via.

10. The IC device of any one of Claims 1 to 9, wherein the BEOL region further comprises a third upper metal line and a fourth upper metal line that extend in parallel with the first upper metal line in the second direction, and are at the same vertical level as the first upper metal line.

11. The IC device of any one of Claims 1 to 10, wherein the first lower metal line and the second lower metal line each comprise the first metal.

12. The IC device of any one of Claims 1 to 11,
wherein the BEOL region further comprises a barrier metal between the second via and the second lower metal line, and
wherein no barrier metal is between the first via and the first lower metal line.

13. The IC device of any one of Claims 1 to 12, wherein the first upper metal line is spaced apart from the second upper metal line in the second direction.

14. The integrated circuit, IC, device of any one of Claims 1 to 13, wherein:
the first lower metal line and the second lower metal line extend in parallel with each other at a first vertical level;
the first via is a ruthenium via at a second vertical level;
the second via is a copper via at the second vertical level;
the first upper metal line is a ruthenium upper metal line that is at a third vertical level;
the second upper metal line is a copper upper metal line that is at the third vertical level; and
the ruthenium upper metal line and the copper upper metal line are collinear in a direction in which the first lower metal line and the second lower metal line are spaced apart from each other.

15. The IC device of Claim 14, wherein the first lower metal line and the second lower metal line comprise respective ruthenium lower metal lines.
